# EUROPÄISCHE PATENTANMELDUNG

(11) **EP 1 282 230 A2**
(43) Veröffentlichungstag der Anmeldung: **05.02.2003**
(21) Anmeldenummer: 02010532.6
(22) Anmeldetag: 10.05.2002
(51) Int. Cl.: H03K 17/082

(54) **Verfahren und Vorrichtung zum Schutz vor Überspannungen beim Abschalten eines Halbleiterschalters**

(30) Priorität: 02.08.2001 DE 10137764
(71) Anmelder: DaimlerChrysler AG, 70567 Stuttgart (DE)
(72) Erfinder: Junge, Günter, 13509 Berlin (DE)

(57) **Zusammenfassung**

Beim vorliegenden Verfahren zum Schutz vor Überspannungen beim Abschalten eines Halbleiterschalters (HS) greift gemäß der Erfindung bei Detektierung einer vordefinierten Überspannungshöhe am Halbleiterschalter (HS) eine ereignisgesteuerte Stromquelle (I1) in den Gatesteuerkreis des Halbleiterschalters (HS) während des Abschaltvorgangs ein, wodurch eine von der Überspannungshöhe abhängige Verlangsamung des Abschaltvorgangs des Halbleiterschalters (HS) herbeigeführt wird. Durch diese Maßnahmen werden unzulässig hohe Spannungsbeanspruchungen des Halbleiterschalters (HS) vermieden.

## Beschreibung

Die Erfindung bezieht sich auf ein Verfahren und eine Vorrichtung zum Schutz vor Überspannungen beim Abschalten eines Halbleiterschalters.

Halbleiterschalter bzw. Leistungshalbleiterschalter, im folgenden kurz HS genannt, wie z.B. Metal Oxide Semiconductor Field Effect Transistoren (MOSFET) oder Insulated- Gate- Bipolar-Transistoren (IGBT) müssen vor unzulässig hohen Spannungsbeanspruchungen geschützt werden. Aufgrund von parasitären Schaltungsinduktivitäten sind Spannungsspitzen beim Abschalten des HS praktisch unvermeidlich. Die dabei zulässigen Spannungsgrenzen als Funktion des Schalterstroms werden vom Halbleiterhersteller als "Sicherer Arbeitsbereich für das Abschalten bzw. Reverse Biase Safe Operating Area (RBSOA)" definiert.

Im Sinne einer effektiven Nutzung des für den HS verwendeten Halbleitermaterials bzw. eines geringen Kühlaufwands ist ein möglichst verlustarmes, d.h. schnelles Schalten und eine hohe Spannungsausnutzung des HS anzustreben.

Da die Abschalt-Überspannung Δu_{DS}= U_{DSü}- U_{d} am HS direkt von der Stromänderungsgeschwindigkeit und der im Schaltkreis wirksamen parasitären Schaltungsinduktivitäten Lₚ abhängt, wobei Δu_{DS}= di_{D}/dt*Lₚ gilt, muß ein Kompromiß zwischen Schaltgeschwindigkeit und Spannungsausnutzung, d.h. der Lastspeisegleichspannung U_{d}, gefunden werden.

Die Schaltgeschwindigkeit eines HS in MOSFET- oder IGBT-Technologie wird üblicherweise durch den verwendeten Gatewiderstand bestimmt. Um die Stromänderungsgeschwindigkeit beim Abschalten merklich zu verringern, sind relativ hochohmige Gatewiderstände im Steuerkreis des HS erforderlich, die zu entsprechend langen und für einen Schaltbetrieb mit hohen Schaltfrequenzen unvertretbaren Schaltverzugszeiten der HS führen würden.

Für MOSFET kommt erschwerend hinzu, das die Durchbruchspannung U_{(BR)DS} des HS möglichst nur wenig über der max. zu sperrenden Spannung liegen sollte, um die mit U_{(BR)DS}^{2.5} ansteigenden Durchlaßverluste P_{Von} des HS klein zu halten.

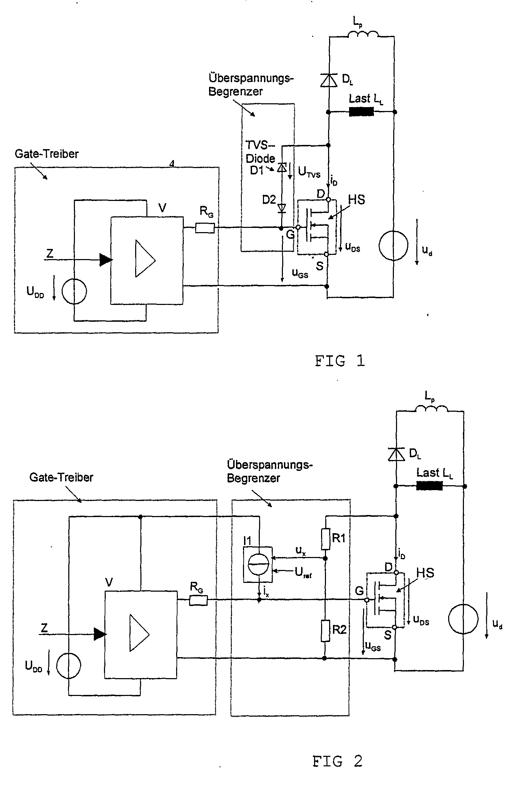

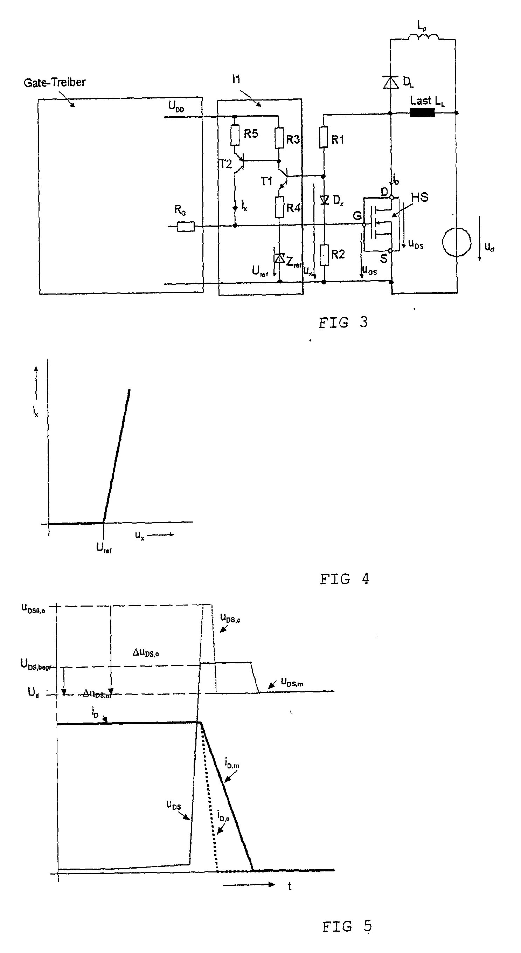

Als Überspannungsschutz gegen periodisch oder einmalig auftretende Schaltüberspannungen werden entsprechend FIG 1 überlicherweise spannungsbegrenzende Baulemente wie Transient Voltage Suppressor-(TVS-) -Dioden mit Zener-Charakteristik verwendet, die zwischen Drain und Gate geschaltet werden und bei auftretender Überspannung das Gate des HS solange aufsteuern, wie die Überspannung anhält. Dadurch wird, wie in FIG 5 dargestellt, die Stromsteilheit soweit herabgesetzt, dass dadurch die Bedingung Δu_{DS}=[(u_{TVS}+u_{GS}) -U_{d}]=Lₚ*di_{D}/dt erfüllt wird.

Die Genauigkeit der tatsächlich erreichbaren Spannungsbegrenzung mittels TVS-Dioden ist abhängig von Fertigungstoleranzen, Temperaturcharakteristik und dynamischer Spannungsänderung bei Stromübernahme der TVS-Dioden. Durch die genannten Toleranzen können sich Probleme insbesondere bei geringer Differenz zwischen zulässiger Sperrspannung U_{(BR)DS} bzw. U_{CES} des HS und Lastspeisegleichspannung U_{d}, wie sie beispielsweise bei MOSFET angestrebt wird, ergeben. So kann es bei Erreichen der unteren Toleranzgrenze zu einem dauerhaften Einschalten des HS sowie zur Zerstörung des HS kommen, wobei U_{TVSmin}<U_{dmax} gilt. An der oberen Toleranzgrenze kann es dagegen zur Zerstörung durch Überschreitung der zulässigen Sperrspannung des HS kommen, mit U_{TVSmax}>U_{(BR)DS} bzw. U_{CES} für IGBT.

Ein periodisches Ansprechen der TVS-Dioden führt insbesondere bei niederohmigem Gatewiderstand R_{G} zu einer hohen Beanspruchung und damit zu einer Beeinträchtigung der Lebensdauer des Bauelements.

Ein Verlust der Sperrfähigkeit der TVS-Dioden würde umfangreiche Zerstörungen der Schaltung zur Folge haben.

Der Erfindung liegt somit die Aufgabe zugrunde, ein Verfahren zum Schutz vor Überspannungen beim Abschalten eines Halbleiterschalters anzugeben, mit dem die oben aufgeführten Nachteile weitgehend vermieden werden können. Außerdem soll eine Vorrichtung zum Durchführen des Verfahrens angegeben werden.

Die erstgenannte Aufgabe wird gelöst durch ein Verfahren zum Schutz vor Überspannungen beim Abschalten eines Halbleiterschalters HS, wobei gemäß der Erfindung bei Detektierung einer vordefinierten Überspannungshöhe am Halbleiterschalter HS eine ereignisgesteuerte Stromquelle I1 in den Gatesteuerkreis des Halbleiterschalters HS während des Abschaltvorgangs eingreift, wodurch eine von der Überspannungshöhe abhängige Verlangsamung des Abschaltvorgangs des Halbleiterschalters HS herbeigeführt wird.

Die zweitgenannte Aufgabe wird gelöst durch eine Vorrichtung zum Durchführen des Verfahrens, wobei gemäß der Erfindung zum Abnehmen des Spannungseingssignals uₓ für die spannungsgesteuerte Stromquelle I1 ein Potentialabgriff A eines Spannungsteilers vorgesehen ist, welcher mit einer zweiten Elektrode eines Spannungsteilerwiderstands R1 verbunden ist, wobei dessen erste Elektrode an den Drain eines MOSFET D angeschlossen ist; der Potentialabgriff A des Spannungsteilers des weiteren mit der Basis eines npn- Bipolartransistors T1 verbunden ist, dessen Emitter mit einer Reihenschaltung, bestehend aus einem Widerstandes R4 und einer Zenerdiode Z_{ref} verbunden ist; das andere Ende der Reihenschaltung mit dem Bezugspotential der Versorgungsspannung U_{DD} des Gate-Treibers bzw. mit dem Source S des MOSFET verbunden ist; der Collector von T1 sowohl mit einem Widerstand R3, dessen andere Elektrode an der Versorgungsspannung U_{DD} liegt, als auch mit der Basis eines pnp- Bipolartransistors T2 verbunden ist, dessen Emitter über einen Widerstand R5 an die Versorgungsspannung U_{DD} angeschlossen ist, und der Collector von T2 an das Gate G des MOSFET angeschlossen ist.

Insbesondere wird dadurch eine ausreichend engtolerierte Spannungsbegrenzung möglich, so dass Halbleiterschalter HS (v.a. MOSFET) eingesetzt werden können, deren Sperrfähigkeit nur knapp oberhalb der Lastspeisegleichspannung liegt, wodurch kostengünstige HS mit niedrigen Durchlaßspannungen und entsprechend geringen Durchlaßverlusten verwendbar sind.

Der Aufwand für die Kühlung kann bei gleichzeitig gestiegenem Wirkungsgrad verringert werden.

Durch die Entkopplung des Steuerungsteils, dem Gate-Treiber, vom Leistungsteil, nämlich der Lastseite, über einen relativ hochohmigen Spannungsteiler R1,R2 anstelle eines Halbleiter-Bauelementes wird eine Zerstörung der Schaltung durch Bauelementeversagen weitestgehend vermieden.

Außerdem wird der Spannungsteiler im Gegensatz zur konventionellen TVS-Diode nicht mit hohen Pulsströmen beim Ansprechen der Begrenzerschaltung belastet. Die zu erwartende Lebensdauer der Widerstände im Spannungsteiler ist ungleich höher anzusetzen als die einer TVS-Diode unter den gegebenen Betriebsbedingungen, zumal wenn hohe Umgebungsperaturen herrschen, wie sie z.B. bei Anwendungen im Kraftfahrzeug mit ϑ_{amb}>100°C auftreten können.

Weitere vorteilhafte Ausgestaltungen der Erfindung sind in den Unteransprüchen wiedergegeben.

Die Erfindung ist anhand mehrerer Ausführungsbeispiele in den FIG näher erläutert. Es zeigen:
- FIG 1: einen Überspannungsbegrenzer mit TVS-Diode nach dem Stand der Technik;
- FIG 2: eine Vorrichtung zum Schutz von Überspannungen an Halbleiterschaltern in schematischer Darstellung;
- FIG 3: eine Detaildarstellung aus FIG 2;
- FIG 4: die U-I-Kennlinie der spannungsgesteuerten Stromquelle I1;
- FIG 5: die idealisierten Strom- Spannungsverläufe am Halbleiterschalter für einen Abschaltvorgang mit (Index "m") und ohne (Index "o") Überspannungsbegrenzer.

Das Prinzipschaltbild ist für den Fall einer MOSFET-Ansteuerung in FIG 2 dargestellt. Anstelle der TVS-Diode D1 in FIG 1 (mit dazu in Reihe geschalteter Sperrdiode D2, die ein Kurzschließen der positiven Gatessteuerspannung U_{GS} über die D-S-Strecke des MOSFET verhindern soll) tritt eine aktive Überspannungsbegrenzerschaltung die als spannungsgesteuerte Stromquelle I1 mit Zener-Charateristik ausgeführt ist. Die Steuerspannung uₓ für I1 wird vom Spannungsabgriff des Spannungsteilers R1, R2 abgenommen, die damit proportional der am MOSFET anliegenden und zu begrenzenden Spannung U_{DS} ist, wobei uₓ= [R2/(R1+R2)]*u_{DS} gilt. Bei Überschreitung einer vorgegebenen Referenzspannung uₓ>U_{ref} liefert die Stromquelle einen Strom iₓ, dessen Stärke sich proportional zur Differenzspannung verhält: (uₓ-U_{ref})= kI*iₓ. Der Verstärkungsfaktor k_{I} wird vorzugsweise sehr groß eingestellt.

Die Höhe der Referenzspannung am Spannungsabgriff des Spannungsteilers wird genau dann erreicht, wenn am MOSFET die vorgesehene Begrenzungsspannung u_{DS}=U_{DS,begr} ansteht. Eine Überschreitung der Begrenzungsspannung u_{DS}>U_{DS,begr} bewirkt dann eine Verlangsamung des Abschaltvorgangs durch Verringerung der Stromsteilheit -di_{D}/dt, da die Stromquelle I1 je nach Höhe der Überschreitung der Begrenzungsspannung dem Gate mehr oder weniger Ladung zuführt, wodurch die Gate-Source-Spannung u_{GS} des MOSFET wieder etwas in positiver Richtung angehoben wird. Dadurch wird die Leitfähigkeit der Drain-Source-Strecke des MOSFET entsprechend erhöht und so der Abschaltvorgang bzw. die Steilheit des abklingenden Drainstroms -di_{D}/dt soweit verringert, bis die Überspannung am MOSFET wieder unter die Begrenzungsspannung U_{DS,begr} abgefallen ist und die Stromquelle I1 keine weitere Ladung dem Gate zuführt. Bei erneuter Überschreitung der Begrenzungsspannung wiederholt sich der beschriebene Vorgang so oft bis der Drainstrom zu Null geworden ist.

Um die durch dieses Regelprinzip bedingte Spannungshysterese und damit die tatsächlich wirksame Überspannung Δu_{DS} am HS klein zu halten, muß der beschriebene Vorgang sich mit hoher Frequenz wiederholen. Dies stellt hohe Ansprüche an die aktive Überspannungsbegrenzerschaltung hinsichtlich kurzer Verzugszeiten und hoher Regelverstärkung (k_{I}→groß).

FIG 3 zeigt die bevorzugte erfindungsgemäße Schaltung des aktiven Überspannungsbegrenzers im Detail. Zur Erfassung der Drain-Source-Spannung U_{DS} des zu schützenden Halbleiterschalters HS, der in diesem Ausführungsbeispiel als MOSFET ausgeführt ist, und zur Bereitstellung eines zur Steuerung der spannungsgesteuerten Stromquelle I1 geeigneten Steuersignals, ist der Spannungsteiler parallel zur D-S-Strecke des MOSFET angeordnet, bestehend aus einer Reihenschaltung der ohmschen Widerstände R1 und R2 sowie wahlweise einer Diode Dₓ im unteren Teil des Spannungsteilers, welche zur Kompensation der temperaturabhängigen Basis-Emitter-Spannung des Bipolar-Transistors T1 in der spannungsgesteuerten Stromquelle I1 dient.

Die Polarität der Diode Dₓ ist dabei so gerichtet, dass bei positiver Drain-Source-Spannung am MOSFET (U_{DS}> 0) ein Strom durch den Spannungsteiler vom Drain D zum Source S des MOSFET fließen kann.

Das Spannungseingssignal uₓ für die spannungsgesteuerte Stromquelle I1 wird am Potentialabgriff A des Spannungsteilers abgenommen, welcher mit der zweiten Elektrode des Spannungsteilerwiderstands R1 verbunden ist, wobei dessen erste Elektrode an den Drain des MOSFET D angeschlossen ist.

Der Potentialabgriff A des Spannungsteilers ist des weiteren mit Basis eines npn- Bipolartransistors T1 verbunden, dessen Emitter mit einer Reihenschaltung, bestehend aus einem Widerstandes R4 und einer Zenerdiode Z_{ref}, die vorzugsweise als spannungsgenaue Referenzdiode ausgebildet sein kann, verbunden ist.

Das andere Ende der Reihenschaltung ist mit dem Bezugspotential der Versorgungsspannung U_{DD} des Gate-Treibers bzw. mit dem Source S des MOSFET verbunden. Der Collector von T1 ist sowohl mit einem Widerstand R3, dessen andere Elektrode an der Versorgungsspannung U_{DD} liegt, als auch mit der Basis eines pnp- Bipolartransistors T2 verbunden, dessen Emitter über einen Widerstand R5 an die Versorgungsspannung U_{DD} angeschlossen ist. Der Collector von T2 ist an das Gate G des MOSFET angeschlossen.

Mit der in FIG 3 dargestellten erfindungsgemäßen Detailschaltung des aktiven Überspannungsbegrenzers läßt sich die Aufgabenstellung auf einfache Weise mit kostengünstigen Bauelementen erfüllen. Außerdem ermöglicht diese Schaltung die Einhaltung der Begrenzungsspannung mit nur sehr kleinen Toleranzen bei weitgehender Temperaturunabhängigkeit.

## Patentansprüche

1. Verfahren zum Schutz vor Überspannungen beim Abschalten eines Halbleiterschalters (HS),
**dadurch gekennzeichnet, dass**
bei Detektierung einer vordefinierten Überspannungshöhe am Halbleiterschalter (HS) eine ereignisgesteuerte Stromquelle (I1) in den Gatesteuerkreis des Halbleiterschalters (HS) während des Abschaltvorgangs eingreift, wodurch eine von der Überspannungshöhe abhängige Verlangsamung des Abschaltvorgangs des Halbleiterschalters (HS) herbeigeführt wird.

2. Verfahren nach Anspruch 1,
**dadurch gekennzeichnet, dass**
die Stromquelle (I1) spannungsgesteuert ist.

3. Vorrichtung zum Durchführen des Verfahrens nach einem der Ansprüche 1 oder 2,
**dadurch gekennzeichnet, dass**
- zum Abnehmen des Spannungseingssignals uₓ für die spannungsgesteuerte Stromquelle (I1) ein Potentialabgriff (A) eines Spannungsteilers vorgesehen ist, welcher mit einer zweiten Elektrode eines Spannungsteilerwiderstands (R1) verbunden ist, wobei dessen erste Elektrode an den Drain eines MOSFET (D) angeschlossen ist,
- der Potentialabgriff (A) des Spannungsteilers des weiteren mit der Basis eines npn- Bipolartransistors (T1) verbunden ist, dessen Emitter mit einer Reihenschaltung, bestehend aus einem Widerstandes (R4) und einer Zenerdiode (Z_{ref}) verbunden ist,
- das andere Ende der Reihenschaltung mit dem Bezugspotential der Versorgungsspannung U_{DD} des Gate-Treibers bzw. mit dem Source (S) des MOSFET verbunden ist,
- der Collector von (T1) sowohl mit einem Widerstand (R3), dessen andere Elektrode an der Versorgungsspannung U_{DD} liegt, als auch mit der Basis eines pnp- Bipolartransistors (T2) verbunden ist,
- dessen Emitter über einen Widerstand (R5) an die Versorgungsspannung U_{DD} angeschlossen ist,
- der Collector vom pnp- Bipolartransistors (T2) an das Gate (G) des MOSFET angeschlossen ist.

4. Vorrichtung nach Anspruch 3,
**dadurch gekennzeichnet, dass**
die Zenerdiode (Z_{ref}) in der Stromquellenschaltung als engtolerierte Spannungs-Referenzdiode ausgeführt ist.

5. Vorrichtung nach Anspruch 3 oder 4,
**dadurch gekennzeichnet, dass** der Spannungsteiler (R1, R2) zum Abgreifen des Spannungseingssignals uₓ für die spannungsgesteuerte Stromquelle (I1) parallel zum Halbleiterschalter (HS) angeordnet ist.

6. Vorrichtung nach einem der Ansprüche 3 bis 5,
**dadurch gekennzeichnet, dass**
zur Kompensation der Temperaturdrift der Basis-Emitter-Strecke des in der Stromquelle verwendeten Transistor (T1) eine Diode (Dₓ) in den unter Teil des Spannungsteilers (R1, R2) geschaltet ist.

7. Vorrichtung nach einem der Ansprüche 3 bis 6,
**dadurch gekennzeichnet, dass**
die Zenerdiode Z_{ref} durch eine Spannungsquelle ersetzt ist.

8. Vorrichtung nach Anspruch 7
**dadurch gekennzeichnet, dass**
die Spannungsquelle steuer oder regelbar ist.

9. Vorrichtung nach Anspruch 8
**dadurch gekennzeichnet, dass**
die Steuerung oder Regelung der Spannungsquelle in Abhängigkeit der Temperatur und/oder der Betriebsspannung erfolgt.

10. Vorrichtung nach einem der Ansprüche 3 bis 6,
**dadurch gekennzeichnet, dass**
die Diode (Dₓ) die Basis-Emitter-Strecke eines Transistors gleichen Typs wie die des Transistors (T1) ist.
